Europäisches Patentamt

(19) European Patent Office

Office européen des brevets

(11) Publication number: **0 001 890**
**B1**

## (12) EUROPEAN PATENT SPECIFICATION

(45) Date of publication of patent specification: **22.07.81**

(21) Application number: **78300490.6**

(22) Date of filing: **11.10.78**

(51) Int. Cl.³: **H 01 L 23/08,**
**H 01 L 23/10, H 01 L 23/56**

(54) Improvements in or relating to microwave integrated circuit packages.

(30) Priority: **12.10.77 GB 4247177**

(43) Date of publication of application:
**16.05.79 Bulletin 79/10**

(45) Publication of the grant of the European patent:
**22.07.81 Bulletin 81/29**

(84) Designated Contracting States:
**DE FR NL SE**

(56) References cited:
**DE - A - 2 020 925**
**FR - A - 2 041 392**
**FR - A - 2 075 958**
**US - A - 3 784 883**
**US - A - 3 872 583**
**US - A - 3 958 195**

(73) Proprietor: **The Secretary of State for Defence in Her Britannic Majesty's Government of the United Kingdom of Great Britain and Northern Ireland Whitehall London S.W.1. (GB)**

(72) Inventor: **Dean, Douglas James**
**68, Brooksby Road Tilehurst**
**Reading Berkshire (GB)**
Inventor: **Linford, Patrick Frederick Terrington**
**6, Bourne Field Sherborne St.John**
**Basingstoke Hampshire (GB)**
Inventor: **Savage, John**
**111, Turnpike Road Newbury**
**Berkshire (GB)**

(74) Representative: **Greenhill, Malcolm Procurement Executive Ministry of Defence et al,**
**Patents 1 A (4) Room 1932, 19th Floor Empress State Building Lillie Road London SW6 1TR (GB)**

Courier Press, Leamington Spa, England.

Improvements in or relating to microwave integrated circuit packages

This invention relates to microwave integrated circuit packages.

When protection of integrated circuits from the harmful effects of moisture and other environmental conditions is required, it is usual to encapsulate them in hermetically sealed packages through with electrical leads — and in the case of MICs, microwave transmission lines — extend to provide electrical and/or electromagnetic coupling to the enclosed circuit. In the particular case of MICs, this packaging typically comprises a hollow machined metal enclosure, microwave coupling to the enclosed MIC being achieved by means of coaxial transmission lines extending through the metal walls of the package, which walls also serve to electromagnetically screen the circuit. Apart from being relatively larger and heavier than the enclosed MIC, and expensive to manufacture, these metal enclosures have a number of disadvantages. The coupling together of a number of such metal-packaged MICs requires coupling from an integrated circuit transmission line, such as microstrip, to a coaxial transmission line and back again. On the other hand, to avoid this problem a number of MICs may be enclosed in a common metal package so that coupling between them can be made using standard integrated circuit techniques such as tape bonding. However, the resulting increase in the package size increases the problem of sealing, and failure of one of the MICs would require the replacement of a larger and therefore more costly unit than would otherwise be the case.

The present invention relates to microwave integrated circuit packages of the kind comprising a first plate of dielectric material for at least indirectly supporting a microwave integrated circuit, a wall of dielectric material sealed to the surface of the first plate, and a second plate of dielectric material providing a lid for sealing over the wall to provide a hermetic enclosure for elements of a microwave integrated circuit supported by the first plate, the first plate of dielectric material carrying planar conductors which define at least one microwave strip transmission line which extends into the enclosure from outside the coupling to the enclosed circuit elements and the conductors which define said transmission line being carried on the surface of the first plate to which the wall is sealed.

Various forms of package of this kind, or structurally similar thereto, are described for example in United States Patents Nos 3 958 195, 3 651 434, 3 872 583, 3 784 883, and 3 715 635, and in French Patent No 2 041 392, although US Patent No 3 872 583 and French Patent No 2 041 392 do not discuss high frequency or microwave applications.

An advantage of packages of this kind in their application to microwave integrated circuits is that they avoid the need for conversion to coaxial transmission line in traversing the walls of the enclosure, as is required in the conventional form of packaging discussed earlier. In those prior art disclosures referred to above which relate to microwave packages, the microwave transmission lines which provide the interconnection between the enclosed circuit and external circuitry comprise continuous strip transmission lines, e.g. microstrip transmission lines passing under or through the side wall of the enclosure.

To avoid losses however, some means is required to compensate for impedance discontinuities or mismatches as the microwave transmission line traverses the wall of the enclosure resulting from the increased dielectric loading in the transition region. US Patent No 3 715 635 proposes a solution in which the width of the transmission line in the region underlying the wall of the enclosure as it passes therethrough is reduced to compensate for the reduction in its characteristic impedance due to the dielectric loading imposed by the wall. However, in such an arrangement any misalignment between the wall and the portions of the transmission line having a reduced cross-section will inevitably introduce further impedance discontinuities due to the abrupt change in the width of the transmission line. This imposes substantial constraints on manufacturing tolerances.

According to the present invention, a microwave integrated circuit package of the kind specified includes means on either side of the wall for compensating in a smoothly or progressively varying manner changes in the characteristic impedance of each said transmission line, whereby the characteristic impedance thereof remains constant or varies smoothly or progressively as the transmission line traverses the wall.

The term microwave strip transmission line is intended to include all forms of transmission line compatible with microwave integrated circuit technology, including microstrip, coplanar waveguide, slot-line and tri-plate.

The invention provides microwave integrated circuit packages in which direct low loss microwave coupling can be made to the enclosed circuit without the need for the usual transition from microwave strip transmission line to coaxial cable. The package can be fabricated using techniques and materials compatible with those used in the fabrication of the transmission lines and the circuit elements.

According to a preferred form of the invention, the change in the characteristic impedance of each said transmission line is reduced as it traverses the wall by a change in the width of the transmission line in the region underlying the wall, and said means for providing a smooth or progressive impedance transition for the transmission line as it traverses the wall comprises a smooth or progressive variation in the width of the said transmission line towards said region of different width underlying the wall.

Alternatively, or in addition to the above-mentioned variation in transmission line width, the change in the characteristic impedance of the or each transmission line as it transverses the wall may be made less abrupt by forming over the transmission line, a dielectric overlay progressively increasing in thickness towards the wall on both sides. Where such an overlay is provided in addition to a progressive variation in the width of the transmission line, the overlay preferably coincides with the progressively narrowing or widening portions thereof in such manner as to maintain the characteristic impedance of the transmission line substantially constant as it traverses the wall.

In addition to, or as an alternative to providing an overlay of this kind, sharp impedance discontinuities in the transmission line may also be reduced by arranging the transmission line to traverse the wall obliquely.

The elements of the enclosed circuit may all be formed on or bonded to the same surface of the first plate as that to which the wall is sealed, i.e., the first plate provides the substrate for the micro-circuit. Alternatively part of all the enclosed circuit may be contained within a recess provided by forming an aperture in the first plate of dielectric material, and sealing a third plate of dielectric material to the surface of the first plate surrounding the aperture, on the opposite side to that to which the wall is sealed.

This latter arrangement enables various circuit elements to be pretested before insertion into the circuit, permits the use of circuit elements formed on or bonded to different substrate materials from that of the first plate, e.g., of ferrimagnetic material or metallic heat sinks, and enables a common package configuration to be used for different circuit designs.

For example, in a preferred microstrip implementation of this latter arrangement, the facing surfaces of the first and third plates of dielectric material are each formed with a continuous layer of conductor to provide the ground plane conductor, and the conductor strip defining the or each transmission line is formed on the opposite face of the first plate, extending outwardly across this face away from the edge of the recess. The ground plane conductor thus extends across the floor of the recess into which elements, e.g. individual microwave active devices and microstrip substrates containing distributed microwave components, can be conductively bonded and then coupled to one another, and to the microstrip conductor strip or strips carried on a second plate using standard techniques. The above-mentioned change in the characteristic impedance of the or each transmission line as it traverses the wall may then be compensated by a reduction in the width of the conductor strip in the region underlying the wall, and each strip may be tapered towards the wall on either side to avoid introducing impedance discontinuities.

To improve the dissipation of heat generated by the microwave circuit enclosed within the package, a plate of high thermal conductivity material, e.g., copper, may be secured in thermal contact with the external face of the first plate of dielectric material (or the third plate, where one is provided). This thermally conducting plate may also conveniently be used to support one or more (adjustable) tuning magnets of known kind for magnetising appropriate areas of a ferrimagnetic material enclosed in the package to provide non-reciprocal microwave components such as microstrip circulators.

The enclosed microwave circuit may be electromagnetically screened by providing conductive layers on appropriate surfaces of the dielectric elements of the package, either internally or externally of the enclosure. Additionally, where such screening is provided externally of the enclosure, an internal layer of resistive material may be provided to absorb microwave energy and damp out currents induced in the screening conductors.

Microwave integrated circuit packages in accordance with the invention may be fabricated using conventional thick film integrated circuit techniques and materials. In a preferred form, the package is fabricated using alumina as the dielectric plate material although in some cases, it may be advantageous to make part of the package of beryllia owing to its higher thermal conductivity.

The invention will now be described in greater detail, by way of example only, with reference to the accompanying drawings of which:

Figure 1 is a diagrammatic cross-sectional view of a microwave integrated circuit package in accordance with the invention;

Figure 2 is a plan view along the line II—II of the package shown in figure 1;

Figure 3 shows on an enlarged scale a detail of the package shown in figure 1;

Figure 4 is a detail of part of a modified MIC package in accordance with the invention, and

Figure 5 is a diagrammatic cross-sectional view of another modified form of MIC package in accordance with the invention.

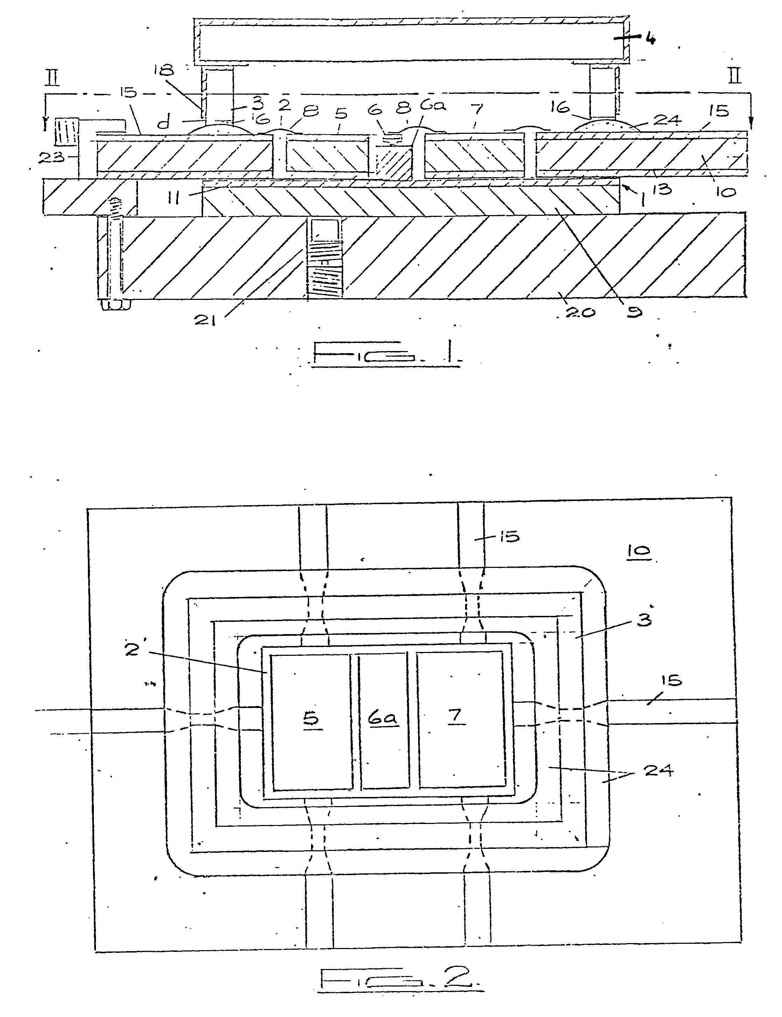

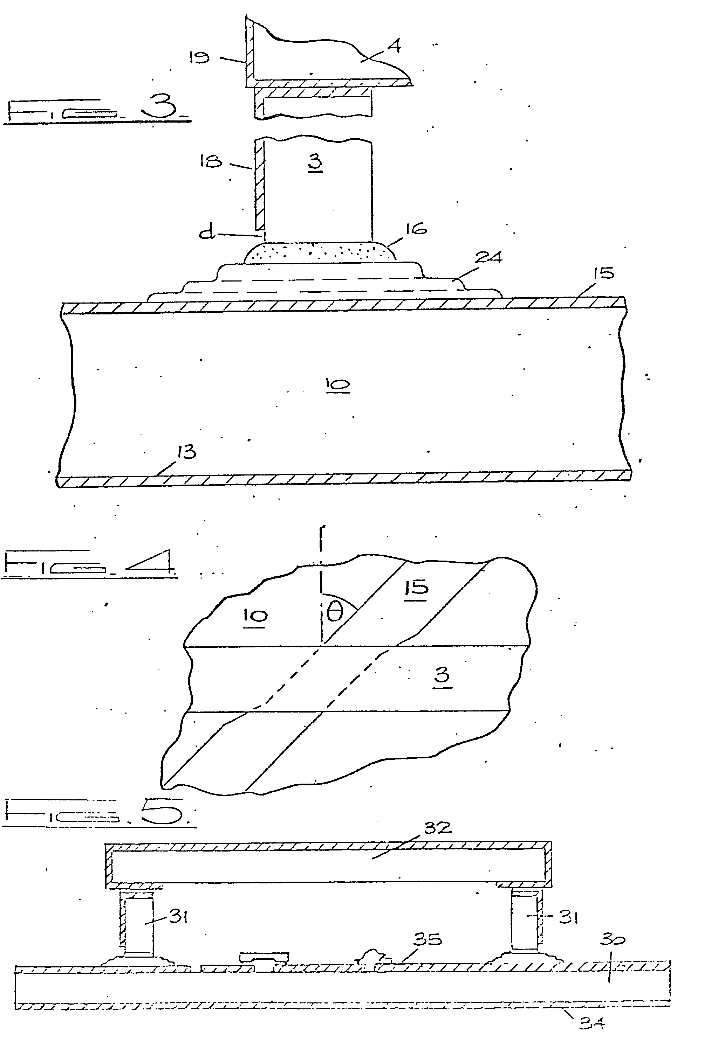

Referring to figures 1 and 2 of the drawings, the package comprises a base 1 having a rectangular recess 2 surrounded by a "window-frame" wall 3 and covered by a lid 4 supported by the wall. The wall 3 is sealed to the base 1 and the lid 4 is sealed to the wall 3 to provide a hermetically sealed enclosure for elements 5, 6, 7 of a microwave integrated circuit (MIC) mounted in the recess 2.

The recessed base 1 is formed from two plates 9, 10 of dielectric ceramic material. alumina (635 $\mu$m thick) in this example. The plate 9 is formed on its upper face with a continuous metallisation layer 11 of, e.g., platinum/gold alloy, and the plate 10 has a central rectangular aperture which may be pressed out from it, before it is fired, or machined out after firing. Plate 10 is also formed on its lower face with a similar continuous metallisation layer 13 to which the upper metallised face of the plate 9 is sealingly soldered over the aperture, to define the recess 2.

The metallisation layer 13 formed on the lower surface of the plate 10 provides the ground plane for a plurality (6) of microstrip conductor strips 15 formed on its upper face, and extending between the edge of the aperture or recess 2 and the periphery of the plate 10.

The rectangular window-frame wall 3 is also of alumina, and is sealed across the upper face of the plate 10 by a glass seal 16 of a known kind. For screening purposes, the external and upper surfaces of the wall 3 are formed with a conducting metallisation layer 18 which is electrically isolated by a small gap $d$ from each of the conductor strips 15. The lid 4, which also comprises a plate of alumina, is also screened on its upper surface, around its edge and around the margin of its lower surface, with a conducting metallisation layer 19. The internal surfaces of the lid 4, and of the wall 3 where necessary, may also be coated with a layer of resistive material for absorbing microwave energy and damping any currents induced in the screening metallisation. The metallised margin of the lid's lower surface is soldered to the metallised upper surface of the wall 3 to completely seal the enclosure. The final sealing operation can thus be carried out at a relatively low temperature to avoid damage to the enclosed circuit elements. The height of the wall must be sufficient to ensure the screening metallisation does not greatly interact with the microwave circuitry, or sufficient to ensure that the interaction effects can be taken into account at the design stage. In the present example, the width of the strips 15 is about 635 $\mu$m, and the wall height is about 2.5 mm, i.e., about 4 times the plate thickness.

In this microstrip implementation of the invention, the ground plane metallisation 13 of the apertured alumina plate 10, in combination with the conductor strips 15 provide a plurality of microwave transmission lines extending into the hermetically sealed enclosure from outside, the strips 15 defining the microwave propagation paths thereof. The metallised floor 11 of the recess 2 is electrically continuous with the microstrip ground plane metallisation 13 and provides an electrically conducting earthed surface to which the ground plane conductors of individual microstrip substrates or microwave semi-conductor devices can be directly bonded, using solder for example. For illustrative purposes only, the package is shown housing two such microstrip substrates 5, 7 and a semi-conductor diode 6 mounted on a copper block 6a. One of the substrates 7 is of alumina, the same dielectric material as the package, while the other substrate 5 is of ferrimagnetic material, for providing non-reciprocal components such as circulators and isolators in known manner. Both substrates 5, 7 are of the same thickness as the alumina plate 10 so when in position, their upper surfaces are coplanar with the upper surface of the plate 10 to facilitate coupling between the conductors carried on these surfaces, for example, by tape bonding (shown only in figure 1). The diode 6 is mounted active region down onto the copper block 6a for heat dissipation purposes. The copper block also raises the level of the active device's upper contact to that of the upper faces of adjacent substrates 5,7 again to facilitate bonding.

Heat generated by the enclosed MIC is dissipated through the plate 9 to which the circuit components are bonded. To improve thermal dissipation, this plate may be of beryllia which has a higher thermal conductivity. Alternatively, or additionally, a heat-sink in the form of a metal plate 20 may be held, e.g., by mechanical clamping, against the outer surface of the plate 10 preferably with a thin layer of thermally conducting grease, sandwiched between them. This heat sink plate 20 also provides means for mounting (screw adjustable) tuning magnets 21 for magnetising appropriate regions of the ferrite substrate 5 to provide non-reciprocal microwave components such as circulators, etc.

The metal plate 20 is mechanically clamped to the package by means of metallic blocks 23 which are fixed to the edge of the plate 10. In the present example these metallic blocks conveniently also provide support for microwave coaxial couplers as shown schematically only in figure 1.

The microstrip conductor strips 15 encounter a change in the dielectric constant of the overlying medium as they traverse the wall 3, giving rise to a sharp decrease in the characteristic impedance of the transmission lines in this region. To compensate for this the strips 15 are of suitably reduced width in the region underlying the wall; and to reduce losses which might otherwise result from an abrupt change in width, the strips 15 are smoothly tapered towards this region of reduced width. Additionally, the abruptness of the change in the characteristic impedance of the transmission lines due to the wall 3 may also be reduced by forming, on top of the strips 15, a dielectric overlay 24 to provide a dielectric loading which progressively increases in thickness towards the wall on both sides.

As shown in figure 3, the overlay 24 is formed from three super-imposed layers of dielectric material having a dielectric constant approximating to that of the wall and deposited using conventional thick film techniques. Each overlay layer corresponds in its general shape to a projection of the wall, successive layers being of reducing width to provide an overall thickness which progressively increases towards both sides of the wall. Each layer is typically fabricated by forming a fused vitreous closed-loop track using an alumina-loaded zero-flow glaze paste, successive layers being deposited after heat-fusion of the preceding layer. The parts of overlay 24 which progressively increase in thickness coincide with the tapering regions of the strips 15 so as to maintain the impedance of the microstrip transmission lines substantially constant as they traverse the wall 3.

The effects of sharp discontinuities in the characteristic impedance of the transmission lines may also be reduced by arranging the tapered conductor strips 15 to traverse the wall 3 obliquely, as shown in figure 4 to produce a similar gradual effect. This technique may be used as an alternative to, or in addition to the overlay technique.

In the fabrication of the package, the microstrip conductors and screening metallisations are first formed as appropriate on the various alumina elements 3, 4, 9 and 10 using conventional thick film fabrication techniques, and the overlay layers are then fabricated. The window-frame wall 3 is then sealed to the surface of the uppermost overlay layer 24 using a glass seal 16, these operations being carried out first because they require temperatures which may damage the enclosed circuit. The metallised surface of the plate 9 can then be bonded to the ground plane metallisation 13 of the plate 10 using high temperature solder. The individual microstrip substrates 5, 7 and solid state devices 6 mounted on copper blocks 6a, may then be bonded to the metallised floor of the recess 2 using solder or conductive epoxy bonding, and these then coupled to one another, and to the conductor strips 15 using tape bonding. The circuit may then be tested, and any defects corrected, before the enclosure is finally completed by sealing the lid 4 to the wall using solder.

The metal plate 20 is then clamped in position, conveniently employing means provided by coaxial or other microwave transmission line connectors or couplers coupled to the package; and any non-reciprocal circuit components may then be turned by adjustment of appropriately positioned tuning magnets 21 carried by the plate 20.

Figure 5 shows a simplified form of microwave integrated circuit package in accordance with the invention in which the base of the package comprises a single ceramic substrate plate 30 which itself provides the supporting substrate for all the elements of the enclosed microwave integrated circuit. The circuit is hermetically enclosed as before, by a ceramic window-frame wall 31 sealed to the surface of the plate 30 surrounding the circuit, and sealed with a lid provided by a ceramic plate 32 covering the wall in exactly the same manner as above.

The plate 30 is formed on its lower face with a ground plane conductor metallisation 34, and on its upper face with a conductor metallisation pattern 35 including conductor strips which interconnect elements of the circuit and provide microstrip transmission line propagation paths which traverse the wall 31 to provide direct microwave coupling to the enclosed circuits from outside the enclosure.

The same techniques as described above are used to compensate for the sudden change in the characteristic impedance of these transmission lines as they traverse the wall, and thereby reduce losses.

For either of the above package configurations the circuit may comprise thick film micro-circuit elements formed on the surface of the main plate (10, 20) by screen printing in conventional manner, together with non-printed components, such as individual semiconductor active devices, inserted into the printed circuitry by bonding at appropriate circuit locations. Where desirable, some or all of the circuit elements, and the conductor metallisations may be formed using thin film fabrication techniques as mentioned earlier.

The package may of course be electromagnetically coupled to other similar microwave packages, or the main plate 10, 30 may carry more than one hermetically enclosed MIC of the kind described above, the circuits being coupled to one another by integrated circuit transmission lines provided on the plate. The apertured plate 10 may also provide a substrate for additional integrated circuitry within or external to the sealed enclosure or enclosures. Furthermore, more than one recess may be provided within a common enclosure.

The screening metallisation of the package, or part of it, may be provided within the enclosure where desirable.

Depending on the degree of hermeticity required, the lid of the package may be sealed over the wall using means other than solder bonding providing that the sealing operation is carried out at a sufficiently low temperature to avoid damaging the enclosed circuit. For example, where a high degree of hermeticity is not essential, epoxy bonding may be used.

Although the invention has been described in its preferred microstrip implementation, it is envisaged that the invention may also be implemented using other forms of integrated circuit mircowave transmission line, such as coplanar waveguide, slot-line or tri-plate.

## Claims

1. A microwave integrated circuit package for housing a microwave integrated circuit, comprising a first plate of dielectric material (10, 30) for at least indirectly supporting a microwave integrated circuit, a wall of dielectric material (3, 31) sealed to the surface of the first plate, and a second plate of dielectric material (4, 32) providing a lid for sealing over the wall to provide a hermetic enclosure for elements of a microwave integrated circuit (5, 6, 7) supported by the first plate, the first plate of dielectric material carrying planar conductors which define at least one microwave strip transmission line (15, 35) which extends into the enclosure from outside for coupling to the enclosed circuit elements and the conductors which define the said transmission line being carried on the surface of the first plate to which the wall is sealed, characterised in that the package includes means on both sides of the wall for compensating in a smoothly or progressively varying manner changes in the characteristic impedance of the transmission line whereby the characteristic impedance of the transmission line remains substantially constant or varies smoothly or progressively as it traverses the wall.

2. A microwave integrated circuit package as claimed in claim 1 wherein the change in the characteristic impedance of each said transmission line is reduced as it traverses the wall by a change in the width of the transmission line (15) in the region underlying the wall (3), and said means for providing a smooth or progressive impedance transition for the transmission line as it traverses the wall comprises a smooth or progressive variation in the width of the said transmission line towards said region of different width underlying the wall.

3. A microwave integrated circuit package as claimed in claim 2 wherein the means for providing a smooth or progressive impedance transition for said transmission line as it traverses the wall (3) further includes dielectric loading material (24) overlying the transmission line regions of progressively or smoothly varying width on either side of the wall, the thickness of the loading material increasing progressively with the varying conductor width towards the wall, such as to maintain the characteristic impedance of the transmission line substantially constant as it traverses the wall.

4. A microwave integrated circuit package as claimed in claim 1 wherein said means for providing a smooth or progressive impedance transition for said transmission line (15) as it traverses the wall (3) comprises dielectric material (24) overlying the transmission line adjacent both sides of the wall and progressively increasing in thickness towards the wall.

5. A microwave integrated circuit package as claimed in claim 3 or 4 wherein said dielectric loading material (24) is formed of a plurality of successive superimposed layers of dielectric material generally corresponding in shape to a projection of the wall (3) on the surface of the first plate of dielectric material (10), the wall being scaled to the surface of the uppermost one of said layers, and the successively superimposed dielectric layers being of progressively decreasing width so that the overall thickness of the loading material overlying said transmission line progressively increases towards both sides of the wall.

6. A microwave integrated circuit package as claimed in claim 5 wherein each of said layers of dielectric material (24) comprises a dielectric-loaded vitreous paste which, after application, has been fired to form a fused dielectric layer having a dielectric constant approximating to that of the material of the wall (3).

7. A microwave integrated circuit package as claimed in any preceding Claim, wherein each said transmission line (15) traverses the wall (3) obliquely.

8. A microwave integrated circuit package as claimed in any preceding claim wherein the mating surfaces of the dielectric wall (3, 31) and the second plate (4, 32) of dielectric material are formed with a metallic coating (18, 19) and are sealed together by solder bonding.

9. A microwave integrated circuit package as claimed in claim 8 wherein the metallic coating (18, 19) extends over substantially the entire external surfaces of the wall (3, 31) and the second plate (4, 32) of dielectric material to provide electro-magnetic screening for the enclosed circuit.

10. A microwave integrated circuit package as claimed in any preceding claim including elements of a microwave integrated circuit (5, 6, 7) housed within the hermetic enclosure and electrically coupled to the transmission line (15) within the enclosure.

11. A microwave integrated circuit package as claimed in claim 10 wherein the enclosed circuit elements (5, 6, 7) are all disposed on the same surface of the first plate (10, 30) as that to which the wall (3, 31) is sealed.

12. A microwave integrated circuit package as claimed in any one of claims 1 to 10 including a third plate of dielectric material, the first plate (10) having an aperture, and the first and third plates (10, 9) providing a base formed by sealing the third plate over the aperture to provide a recess (2) in the base in which at least one of the elements (5, 6, 7) of a microwave integrated circuit can be mounted before sealing the enclosure by means of said wall surrounding the recess and the second plate (4) of dielectric material, the adjacent surfaces of the first and third plates (10, 9) of dielectric material each being formed with a continuous metallization layer (13, 11), that formed on the first plate (10) providing a ground plane conductor for each said transmission line, and that formed on the third plate (9) providing a conducting floor for the recess electrically continuous with the ground plane conductor.

## Revendications

1. Un ensemble pour circuit intégré à micro-ondes destiné à servir de boîter à un circuit intégré à micro-ondes, comportant une première plaque de matériau diélectrique (10, 30) pour le support au moins indirect d'un circuit ingégré, à micro-ondes une paroi de matériau diélectrique (3, 31) scellée sur la surface de la première plaque et une deuxième plaque de matériau diélectrique (4, 32) constituant un couvercle scellé sur la paroi, servant à enfermer hermétiquement les éléments d'un circuit intégré (5, 6, 7) à micro-ondes supporté par la première plaque, la première plaque de matériau diélectrique portant les conducteurs planaires qui définissent au moins une ligne de transmission haute fréquences (13, 15) qui s'étend jusqu'à pénétrer l'enclos précité de l'extérieur pour le couplage des éléments du circuit qui y sont enfermés aux conducteurs qui définissent ladite ligne de transmission portée sur la surface de la première plaque sur laquelle la paroi est scellée, caractérisé par le fait que l'ensemble comporte des deux côtés de cette paroi les moyens permettant de compenser de façon égale ou de manière graduelle les changements intervenant dans l'impédance caractéristique de la ligne de transmission de sorte que cette impédance caractéristique de ladite ligne demeure largement constante ou varie de façon égale ou graduelle alors qu'elle passe à travers la paroi.

2. Un ensemble pour circuit intégré à micro-ondes tel qu'il est affirmé dans la revendication 1 où le changement dans l'impedance caractéristique de la ligne de transmission est réduite lorsqu'elle traverse la paroi de par un changement dans la dite ligne (15) dans la partie située, sous la paroi (3) et les dits moyens permettant une transition d'impédance de nature égale ou graduelle pour la ligne de transmission lorsq'elle traverse la paroi, comporte une variation égale ou graduelle de la longeur de cette même ligne de transmission vers la dite partie située sous la paroi.

3. Un ensemble pour circuit intégré à micro-ondes tel qu'il est affirmé dans la revendication 2 où les moyens assurant une transition d'impédance de nature égale ou graduelle pour la ligne de transmission lorsqu'elle passe à travers la paroi (3), comporte en outre un matériau de charge diélectrique situé au-dessus des parties de cette ligne, dont la largeur varie de façon égale ou graduelle de chaque côté de la paroi, l'épaisseur de ce matériau augmentant de manière égale ou graduelle en fonction de la largeur du conducteur en direction de la paroi, de façon à conserver à l'impédance caractéristique de la ligne de transmission une valeur constante lors de son passage à travers ladite paroi.

4. Un ensemble pour circuit intégré à micro-ondes tel qu'il est affirmé dans la revendication 1 où lesdits moyens assurant une transition de nature égale ou graduelle de l'impédance pour ladite ligne de transmission (15) lorsqu'elle traverse la paroi (3), comportent le matériau diélectrique (24) situé sur la ligne de transmission adjacente aux des côtés de la paroi et augmentant graduellement d'épaisseur en direction de cette paroi.

5. Un ensemble pour circuit intégré à micro-ondes tel qu'il est affirmé dans la revendication 3 ou 4, oú ledit matériau de charge diélectrique (24) est consitué de plusieurs couches successivement surperposées de matériau diélectrique dont la forme correspond de façon générale à une projection de la paroi (3) sur la surface de la première plaque de matériau diélectrique (10), la paroi étant scellée à la surface de la toute première desdites couches, et les couches de matériau diélectrique surpoposées les unes sur les autres dont la largeur diminue graduellement de sorte que l'épaisseur d'ensemble du matériau de charge couvrant ladite ligne de transmission augmente graduellement en direction des deux côtés de la paroi.

6. Un ensemble pour circuit intégré à micro-ondes tel qu'il est affirmé dans la revendication 5, oú chacune desdites couches de matériau diélectrique (24) comporte une pâte vitreuse chargée de (matériau) diélectrique qui après application a fait l'objet d'une mise à feu en vue de constituer une couche diéléctrique dotée d'un fusible ayant une constante diélectrique approximativement égale à celle du matériau de la paroi (3).

7. Un ensemble pour circuit intégré à micro-ondes tel qu'il est affirmé dans la revendication précédente, où chacune desdites lignes de transmission passe à un angle oblique à travers la paroi (3).

8. Un ensemble pour circuit à micro-ondes intégré tel qu'il est affirmé dans n'importe laquelle des revendications précédentes où les surfaces correspondantes de la paroi diélectrique (3, 31) et de la deuxième plaque (4, 32) de matériau diélectrique sont formées d'une couche métallique (18, 19) et sont soudées l'une à l'autre à l'aide d'une soudure de métallisation.

9. Un ensemble pour circuit intégré à micro-ondes tel qu'ils est affirmé dans la revendication 8 où la couche métallique (18, 19) s'étend plus ou moins sur toutes les surfaces extérieures de la paroi (3, 31) et de la deuxième plaque (4, 32) de matériau diélectrique pour assurer la protection électromagnétique du circuit enfermé.

10. Un ensemble pour circuits intégrés à micro-ondes tel qu'il est affirmé dans n'importe laquelle des revendications précédentes y compris les éléments d'un circuit intégré à micro-ondes contenu (5, 6, 7) dans l'espace enclos hermétique et couplé électriquement à la ligne de transmission (15) à l'intérieur de cet espace enclos.

11. Un ensemble pour circuit intégré à micro-ondes tel qu'il est affirmé dans la revendication 10 où les éléments d'un circuit intégré à micro-ondes enfermés (5, 6, 7) sont tous disposés sur la même surface de la première plaque (10, 30) à laquelle la paroi (3, 31) est scellée.

12. Un ensemble pour circuit intégré à micro-ondes tel qu'il est affirmé dans le revendication 1 à 10 y compris une troisième plaque (9) du matériau diélectrique, la première plaque (10) ayant une ouverture, tandis que les première et troisième plaques constituent une base formée en scellant la troisième plaque sur l'ouverture, ceci constituant un logement dans la base où au moins un des éléments (5, 6, 7) d'un circuit intégré à micro-ondes peut être monté avant que l'espace clos précité ne soit scellé par la paroi entourant le logement et la deuxième plaque (4) de matériau diélectrique, les surfaces adjacentes des première et troisième plaques (9, 10) du matériau diélectrique, chacune étant constituée d'une couche continue de métallisation (13, 11) formée sur la première plaque (10), ceci constituant un conducteur plan au sol pour chacune desdites lignes de transmission, tandis que la couche de métallisation sur la troisième plaque (9) constitue un plancher conducteur pour le logement, qui assure une continuité électrique avec le conducteur plan au sol.

## Patentansprüche

1. Eine integrierte Mikrowellen-Schaltkreismontage zur Unterbringung eines integrierten Mikrowellen-Schaltkreises, bestehend aus einer ersten Karte aus Isoliermaterial (10, 30) zur mindestens indirekten Abstützung einer integrierten Mikrowellen-Schaltung, einer Wand aus nichtleitendem Material (3, 31) an die Oberfläche der ersten Karte dicht angeschlossen und einer zweiten Karte aus nichtleitendem Material (4, 32), einen Deckel darstellend zur hermetischen Abdichtung der Elemente eines integrierten Mikrowellen-Schaltkreises (5, 6, 7), abgestützt durch die erste Karte, die erste Karte aus nichtleitendem Material trägt Planarleiter, welche mindestens ein Mikrowellenstreifenübertragungsleitung definieren (13, 15), welche von Außen in die Umkleidung reicht, zum Anschluß an die eingeschlossenen Schaltkreiselemente, wobei die Leiter, welche die oben genannte Übertragungsleitung definieren, auf der Oberfläche der ersten Karte liegen an welche die Wand dicht angesschlossen ist, gekennzeichnet dadurch, daß die Montage beiderseits der Wand mit Möglichkeiten ausgestattet ist, Änderungen in der charakteristischen Impedanz der Übertragungsleitung auf gleichmäßiger oder fortschreitend veränderlicher Art zu kompensieren, wobei die charakteristische Impedanz der Übertragungsleitung im Wesentlichen konstant bleibt, oder gleichmäßig oder fortschreitend schwankt, sowie sie die Wand durchdringt.

2. Eine integriete Mikrowellen-Schaltkreismontage wie unter Anspruch 1 behaupet, wobei die Änderung der charakteristischen Impedanz jeder der besagten Übertragungsleitungen beim Durchdringen der Wand von einer Veränderung der Breite der Übertragungsleitung verringert wird (15), und zwar im Bereich unterhalb der Wand (3), wobei die besagte Möglichkeit, für die Übertragungsleitung beim Durchdringen der Wand einen gleichmäßigen oder fortschreitenden Impedanzübergang zu bieten, eine gleichmäßige oder fortschreitende Breitenveränderung besagter Übertragungsleitung in der Richtung des besagten Bereichs verschiedener Breite unterhalb der Wand umfaßt.

3. Eine integrierte Mikrowellen-Schaltkreismontage wie unter Anspruch 2 behauptet, wobei die Möglichkeit, der besagten Übertragungsleitung beim durchdringen der Wand (3) einen gleichmäßigen oder fortschreitenden Impedanzübergang zu bieten, zusätzlich einen nichtleitenden Füllstoff umfaßt (24), der die Übertragungsleitungszonen gleichmäßiger oder fortschreitend veränderlicher Breite beiderseits der Wand überdeckt, wobei die Dicke des Füllstoffes mit der veränderlichen Leitungsbreite gegen die Wand hin zunimmt, womit die charakteristische impedanz der Übertragungsleitung beim durchdringen der Wand weitgehend gleich bleibt.

4. Eine integrierte Mikrowellen-Schaltkreismontage wie unter Anspruch 1 behauptet, wobei besagte Möglichkeit, für die besagte Übertragungsleitung (15) beim durchdringen der Wand (3) einen gleichmäßigen oder fortschreitenden Impedanzübergang zu bieten, nichtleitendes Material umfaßt (24) das beiderseits der Wand die Übertragungsleitung überdeckt und dessen Dicke gegen die Wand zu fortschreitend zunimmt.

5. Eine integrierte Mikrowellen-Schaltkreismontage wie unter Anspruch 3 oder 4 behauptet, wobei besagtes nichtleitendes Füllmaterial (24) aus einer Mehrzahl aufeinanderfolgender Schichten nichtleitenden Materials besteht, und welches im allgemeinen einem Vorsprung in der Wand (3) der ersten Karte aus nichtleitendem Material entspricht (10), wobei die Wand an die Oberfläche der ersten der besagten Schichten dicht angeschlossen ist, und die folgenden aufeinander gelegten Schichten fortschreitend an Breite abnehmen, so daß die Gesamtdicke des Füllstoffes welches besagte Übertragungsleitung deckt, gegen beide Seiten der Wand hin fortschreitend zunimmt.

6. Eine integrierte Schaltkreismontage wie unter Anspruch 5 behauptet, wobei jede der besagten Schichten aus nichtleitendem Material (24) eine dialektrisch-geladene, glasartige Masse umfaßt, welche nach dem Auftragen gebrannt wird und dann eine geschlossene, nichtleitende Lage darstellt, welche eine nichtleitende Konstante besitzt, die ungefähr jener des Materials der Wand (3) entspricht.

7. Eine integrierte Mikrowellen-Schaltkreismontage wie im vorhergehendeh Anspruch behauptet, wobei jede der Übertragungsleitungen (15) die Wand (3) schräg durchquert.

8. Eine integrierte Mikrowellen-Schaltkreismontage wie in einem jeden der vorhergehenden Ansprüche behauptet, wobei die aufeinanderliegenden Flächen der nichtleitendem Wand (3, 31) und der zweiten Karte (4, 32) aus nichtleitendem Material mit einem Metallüberzug (18, 19) gebildet und mittels Verbundlöten fest miteinander verbunden sind.

9. Eine integrierte Mikrowellen-Schalkreismontage wie in Anspruch 8 behauptet, wobei die metallische Beschichtung (18, 19) sich praktisch über die ganzen Außenflächen der Wand (3, 31) und der zweiten Karte (4, 32) aus nichtleitendem Material erstreckt und für den eingeschlossenen Schaltkreis eine elektromagnetische Abschirmung bildet.

10. Eine integrierte Mikrowellen-Schaltkreismontage wie in einem jeden der vorhergehenden Ansprüche behauptet, einschließlich der Elemente eines integrierten Mikrowellen-Schaltkreises, eingeschlossen (5, 6, 7) in dem hermetischen Verschluß und elektrisch angeschlossen an die Übertragungsleitung (15) innerhalb der Einfassung.

11. Eine integrierte Mikrowellen-Schaltkreismontage wie unter Anspruch 10 behauptet, wobei die eingeschlossen Schaltkreiselemente (5, 6, 7) alle auf derselben Fläche der ersten Karte bestückt sind (10, 30) an welche die Wand (3, 31) dicht angeschlossen ist.

12. Eine integrierte Mikrowellen-Schaltkreismontage wie in jedem der Ansprüche 1 bis 10 behauptet, eine dritte Karte (9) aus nichtleitendem Material beinhaltend, worin die erste Karte (10) eine Öffnung hat und die erste und die dritte Karte (9) eine Unterlage bilden, indem die dritte Karte fest über die Öffnung angeschlossen wird und so eine Aussparung (2) bildet, auf deren Grund mindestens eines der Elemente (5, 6, 7) der integrierten Mikrowellenschaltung montiert werden kann, bevor die Umfassung mittels der die Aussparung umgebenden Wand und der zweiten Karte aus nichtleitendem Material (4) versiegelt wird, wobei die benachbarten Flächen der ersten und der dritten Karte aus nichtleitendem Material (9, 10) mit einer durchgehenden metallisierenden Schicht ausgebildet sind (13, 11) wobei die auf der ersten Karte (10) gebildete einen Grundflächenleiter für jede der besagten Übertragungsleitungen bildet und jene auf der dritten Karte gebildete (9) einen Leitungsboden für die Aussparung bildet welche mit dem Grundflächenleiter elektrisch durchgehend verläuft.

FIG. 1

FIG. 2

0 001 890

FIG.3.

FIG.4.

FIG.5.

2